# FASCICULE DE BREVET EUROPEEN

(11) **EP 0 554 178 B1**
(45) Date de publication et mention de la délivrance du brevet: **23.07.1997**
(21) Numéro de dépôt: 93400210.6
(22) Date de dépôt: 28.01.1993
(51) Int. Cl.: H01L 33/00, H01S 3/19, H01S 3/25

(54) **Amplificateur optique à semiconducteur à faible temps de commutation**
Optischer Halbleiterverstärker mit kurzer Schaltzeit
Semi-conductor optical amplifier with short switching time

(30) Priorité: 31.01.1992 FR 9201083
(43) Date de publication de la demande: 04.08.1993
(73) Titulaire: FRANCE TELECOM, 75015 Paris (FR)
(72) Inventeur: Deveaud-Pledran, Benoit, F-22300 Lannion (FR)
(74) Mandataire: Signore, Robert

(56) Documents cités:
- EP-A- 0 280 281
- EP-A- 0 390 167
- EP-A- 0 483 687
- US-A- 4 745 452
- APPLIED PHYSICS LETTERS. vol. 59, no. 5, 29 Juillet 1991, NEW YORK US pages 504 - 506 S. IKEDA ET AL. 'Evidence of the wavelength switching caused by a blocked carrier transport in an asymmetric dual quantum well laser'
- APPLIED PHYSICS LETTERS. vol. 55, no. 12, 18 Septembre 1989, NEW YORK US pages 1155 - 1157 S. IKEDA ET AL. 'Asymmetric dual quantum well laser-wavelength switching controlled by injection current'

## Description

### Domaine technique

La présente invention a pour objet un amplificateur optique à semiconducteur à faible temps de commutation. Elle trouve une application en télécommunications optiques.

### Etat de la technique antérieure

Pour obtenir un faisceau optique commuté, on peut utiliser un laser oscillateur et commuter ce laser mais on peut aussi utiliser un laser émettant en continu, amplifier le faisceau continu dans un amplificateur et commuter cet amplificateur. Cette commutation "externe" est plus facile à mettre en oeuvre que la commutation "interne". Mais elle n'est possible que si la durée de vie des porteurs dans les états actifs de l'amplificateur est suffisamment courte. Une solution qui a été envisagée pour réduire cette durée de vie consiste à irradier avec des électrons la structure amplificatrice. Mais cette solution a l'inconvénient de détruire la qualité des couches semiconductrices et de réduire la durée de vie du système.

Pour résoudre ce problème de manière satisfaisante, la présente invention a recours à une structure qui est du genre à puits quantiques. Avant de décrire l'invention en détail, on peut rappeler que, depuis quelques années, on s'intéresse à une nouvelle classe de structures appelées puits quantiques ou, dans une variante plus complexe, multi-puits quantiques ("Multiple Quantum Well" en terminologie anglosaxonne ou MQW en abrégé).

Un puits quantique est obtenu en insérant entre deux couches minces d'un premier matériau semiconducteur une couche mince d'un second matériau ayant une bande interdite plus faible que celle du premier. Un puits de potentiel est ainsi créé pour les porteurs de charge dans le semiconducteur central qui a la plus faible bande interdite, ce puits étant encadré par deux barrières de potentiel correspondant aux deux couches latérales. On obtient un multi-puits quantique en superposant de telles structures, sans qu'il existe de couplage entre les puits (ce qui s'obtient en donnant aux barrières une épaisseur suffisante).

Le document EP-A-0 280 281 décrit ainsi une structure laser à deux puits quantiques séparés par une barrière de potentiel. Cette structure est capable d'osciller sur deux longueurs d'onde. Mais il n'y a pas de couplage entre les deux puits.

Le document EP-A-0 390 167 décrit encore un dispositif à double puits capable d'osciller sur deux longueurs d'onde différentes. La rétroaction est obtenue par un réseau de Bragg distribué.

L'article de Appl. Phys. Letters, 59 (1991) 29 July, n°5, pp. 504-506 décrit encore une structure à deux puits quantiques, qui émet sur deux longueurs d'onde différentes. Les deux puits quantiques sont séparés par une barrière de potentiel, laquelle est suffisante épaisse et haute pour éviter le transport des porteurs d'un puits à l'autre. Cette structure est susceptible d'émettre sur les deux longueurs d'onde définies par les deux puits quantiques.

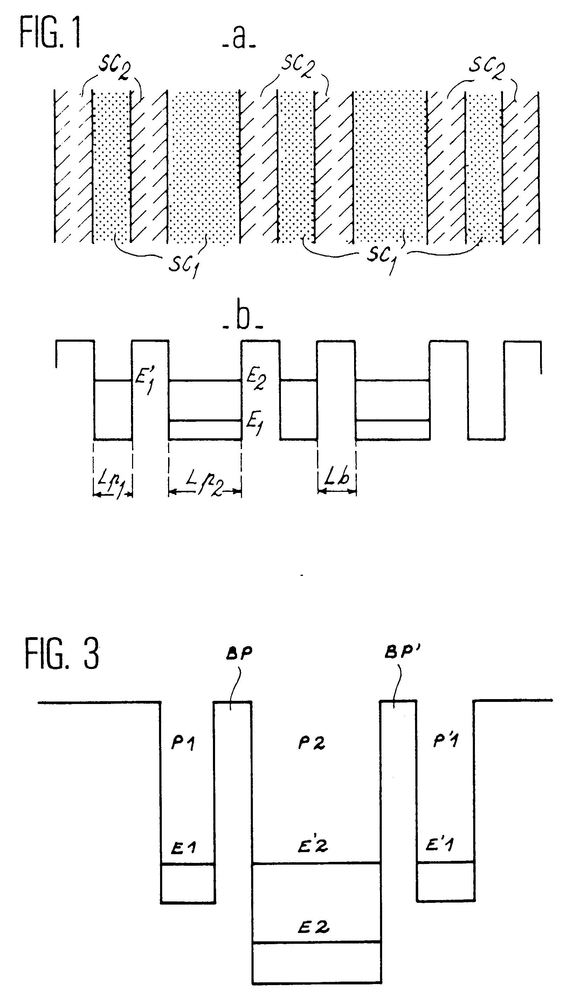

Si de telles structures sont utilisées pour réaliser des lasers, elles peuvent l'être également pour réaliser des absorbants saturables. Le document FR-A-2 589 630 décrit un absorbant saturable à très faible temps de commutation. La structure utilisée est représentée sur la figure 1 annexée. On voit, sur cette figure, (partie a), un empilement de couches de deux matériaux semiconducteurs SC₁ et SC₂, l'épaisseur des couches de SC₂ étant toujours la même, mais l'épaisseur des couches de SC₁ étant égale soit à une faible valeur Lp₁, soit à une forte valeur Lp₂. Sur la partie b), on voit le diagramme d'énergie de la bande de conduction (la bande de valence n'est pas représentée mais elle a une allure similaire quoique symétrique). Des barrières de largeur Lb séparent des puits de largeur alternativement Lp₁ et Lp₂. Dans les puits larges, le plus bas niveau d'énergie E₁ est situé en dessous du niveau E'₁, qui est le plus bas niveau dans les puits étroits.

Dans un tel dispositif, l'absorption saturable est obtenue dans les puits étroits tandis que les puits larges servent à recueillir les porteurs photo-excités qui ont été créés dans les puits étroits adjacents.

L'introduction d'un puits élargi a pour effet de créer, dans ce puits, un ou des niveaux d'énergie situés en dessous du niveau d'énergie le plus bas de la bande de conduction (pour les électrons) et au-dessus du niveau d'énergie de la bande de valence (pour les trous). Les porteurs ont donc tendance à s'accumuler dans le ou les puits large(s) sur les niveaux d'énergie faible.

Bien que satisfaisants à certains égards, (des temps de l'ordre de la picoseconde ont été obtenus) ces dispositifs soulèvent un problème lié à l'évacuation des porteurs du puits large, si l'on utilise un tel dispositif à des fréquences de répétition élevées. On peut essayer de résoudre ce problème en vidant le puits large par effet laser. Ce principe a été démontré pour les absorbants saturables (cf l'article de J.L. OUDAR et J.A. LEVENSON, International Quantum Electronics Conference, IQEC'88 (Optical Society of America), Technical Digest, p. 626, 1988). Mais il nécessite l'utilisation de puissances d'excitation très élevées, et ne fonctionne que dans une plage de température restreinte.

### Exposé de l'invention

La présente invention reprend l'idée d'un puits principal couplé (à travers une barrière de potentiel) à un puits auxiliaire, ce dernier étant chargé de recueillir les porteurs du puits principal. Pour cette raison, on peut qualifier le second puits de puits "poubelle" par opposition au premier puits qui est un puits "actif". L'invention utilise des matériaux tels que le puits actif permette l'amplification souhaitée à La longueur d'onde, alors que le puits poubelle va contribuer à vider rapidement le puits actif lorsque l'excitation électrique aura cessé et va se dépeupler lui-même par effet laser, sans toutefois qu'une amplification puisse s'établir également à travers le puits poubelle, ce qui ruinerait naturellement la possibilité de moduler rapidement l'amplification à la longueur d'onde recherchée.

Pour cela, la structure de l'invention est pourvue de couches transparentes déposées sur les faces latérales de la structure (en pratique sur les faces perpendiculaires au plan des couches), ces couches étant choisies dans leur nature et leur épaisseur pour constituer des couches semiréfléchissantes à la longueur d'onde correspondant au puits poubelle où doit avoir lieu l'effet laser chargé de dépeupler ce puits, et pour constituer simultanément des couches antireflet à la longueur d'onde correspondant au puits actif où a lieu l'amplification.

De façon précise, la présente invention a pour objet un amplificateur optique à faible temps de commutation qui est conforme à la revendication 1.

### Brève description des dessins

- La figure 1, déjà décrite, montre la structure de bandes d'un absorbant saturable selon l'art antérieur ;
- la figure 2 montre la structure de bandes d'un amplificateur selon l'invention ;
- la figure 3 montre une variante à deux puits actifs encadrant un puits poubelle ;
- la figure 4 illustre une variante à couches de confinement graduelles ;
- la figure 5 montre la structure générale d'un amplificateur selon l'invention.

### Exposé détaillé d'un mode de réalisation

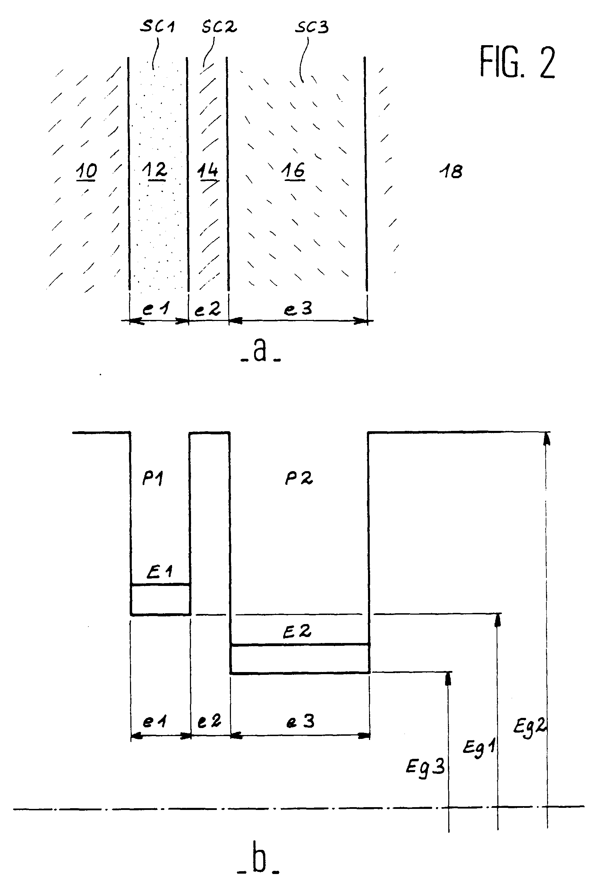

On voit, sur la figure 2, une structure amplificatrice selon l'invention avec ses différentes couches (partie a) et ses bandes d'énergie (partie b).

Telle que représentée la structure comprend :
- une première couche 12, en un premier semiconducteur SC₁ ayant une bande interdite Eg₁, cette première couche ayant une épaisseur e₁ ;
- une deuxième couche 14 en un deuxième semiconducteur SC₂ ayant une bande interdite Eg₂ supérieure à la bande Eg₁ de SC₁ et ayant une deuxième épaisseur e₂ ;
- une troisième couche 16, en un troisième semiconducteur SC₃ ayant une bande interdite Eg₃ inférieure à la bande Eg₁ du premier semiconducteur, cette troisième couche 16 ayant une épaisseur e₃ qui, dans l'exemple illustré, est plus grande que l'épaisseur e₁ de la première couche 12.

Il est ainsi constitué un puits quantique peu profond et étroit P1 dans la couche 12, ce puits étant couplé à un puits quantique profond et large P2 dans la couche 16 à travers une barrière de potentiel BP correspondant à la couche 14.

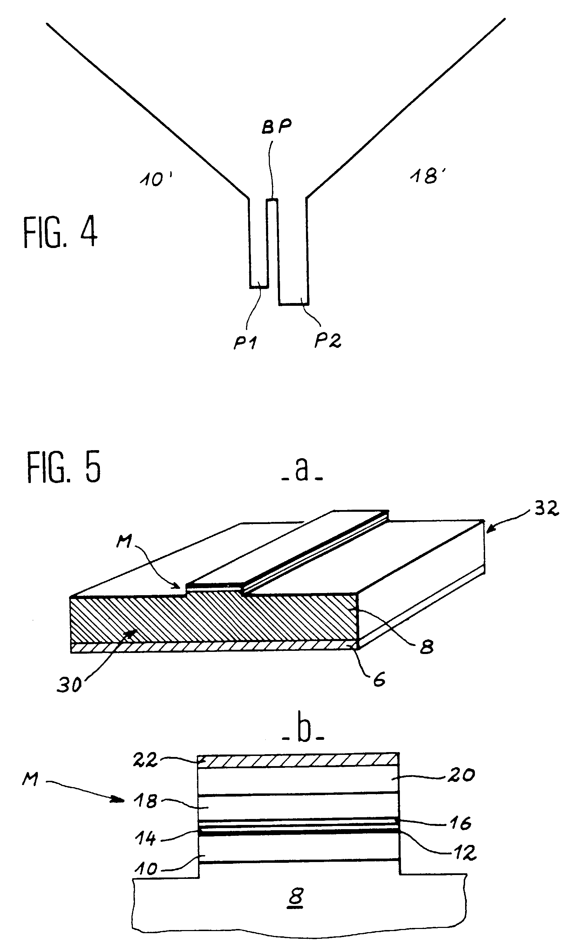

Cet empilement de trois couches 12, 14, 16 est encadré par deux couches de confinement optique, respectivement 10 et 18. Ces couches peuvent être par exemple en un semiconducteur identique au deuxième semiconducteur SC₂ servant à créer la barrière de potentiel. Mais on verra un autre mode de réalisation à propos de la figure 4.

Comme on le comprendra mieux par la suite en liaison avec la figure 5, la structure comprend encore deux couches en matériau transparent, non visibles sur la figure 2 et perpendiculaires au plan des couches 12, 14 et 16 (donc parallèles au plan de la figure). Ces couches constituent des couches antireflet pour la longueur d'onde λ1 correspondant à l'énergie de la bande interdite Eg₁ du premier semiconducteur SC₁ constituant le puits peu profond et étroit P₁ et constituant des couches à réflexion partielle pour la longueur d'onde λ2 correspondant à l'énergie de la bande interdite Eg₃ du troisième semiconducteur SC₃ constituant le puits profond et large P₂. L'amplification optique s'effectue alors à la longueur d'onde λ1 correspondant au puits peu profond et étroit P₁, l'effet laser se produisant à la longueur d'onde λ2 correspondant au puits profond et large P₂ en raison des miroirs semifléchissants encadrant ce puits.

Le premier semiconducteur SC₁ dans lequel est formé le puits P₁ étroit et peu profond peut être en InₓGa₁₋ₓAs avec une concentration x en indium de 52% et le troisième semiconducteur SC₃ dans lequel est formé le puits P₂ profond et large en InGaAs mais avec une concentration en indium plus élevée, de 65% environ.

Ces compositions correspondent à des longueurs d'onde λ1 et λ2 respectivement de 1,5 microns et 1,9 microns.

Quant au deuxième semiconducteur SC₂ formant la barrière de potentiel, il peut être en In₁₋ₓGaₓAs_{y}P_{1-y} avec x de l'ordre de 47% pour obtenir des couches adaptées à un substrat en InP. On pourra prendre pour y 20% ce qui correspond à une bande interdite de largeur 1,2 eV à 300 K ou 35%, ce qui donne une bande interdite de 1,1 eV ou 50% pour obtenir une bande de 1 eV.

Avec une telle structure, on peut utiliser des couches antireflet en SiO d'épaisseur 210 nm. Une telle couche présente un coefficient de réflexion inférieur à 10⁻³ à la longueur d'onde d'amplification λ1 (1,55 microns) et de 4,5% à la longueur d'onde λ2 (1,9 microns) de l'effet laser dans le puits poubelle. On peut améliorer l'écart de réflectivité en utilisant une couche d'épaisseur 630 nm. Le coefficient de réflexion passe alors à 24%. En portant l'épaisseur à 1,05 microns, on obtient un coefficient de réflexion de 30%, toujours à 1,9 microns de longueur d'onde.

Des compositions multicouches, par exemple en TiO₂/SiO₂ permettent de conserver un coefficient de réflexion inférieur à 10⁻³ à la longueur d'onde λ1 d'amplification (1,55 microns) tout en faisant passer la réflectivité au-dessus de 70% à la longueur d'onde λ2 de l'effet laser (1,9 microns).

La figure 3 illustre une variante dans laquelle un puits large et profond P2 est intercalé entre deux puits étroits et peu profonds P1 et P'1 avec deux barrières de potentiel BP et BP'.

Dans cette variante, la densité d'états est deux fois plus grande que dans le cas simple schématisé de la figure 2. Pour aller plus loin dans cette direction, on peut, en outre, réaliser des largeurs de puits et des compositions telles que le niveau n=2 du puits poubelle (E'2 sur la figure 3) se trouve en résonance avec les niveaux n=1 des deux puits actifs E1, E'1. On aboutit ainsi à une densité d'états triple de celle du dispositif de départ. On peut obtenir les résonances indiquées pour tout un ensemble de paramètres, par exemple :
- les deux puits actifs ont une composition de 53% en indium et une largeur de 5,8 nm,
- le puits poubelle est réalisé avec une composition en indium de 65% et sa largeur est de 10 nm.

Si l'on prend pour référence d'énergie le bas de la bande de conduction de l'InGaAs à 65%, on obtient la succession suivante de niveaux : un niveau à 35 meV pour les électrons n=1 du puits poubelle, et trois niveaux en résonance à 132 meV pour les électrons n=1 des deux puits actifs et pour les électrons n=2 du puits poubelle.

Sur les figures 2 et 3, les couches de confinement 10, 18 qui encadrent la structure sont supposées être d'une composition constante sur toute leur épaisseur. Mais il entre dans le cadre de l'invention d'utiliser des couches de confinement à composition graduelle comme illustré sur la figure 4. Sur cette figure, on retrouve un puits peu profond et étroit P1 et un puits poubelle P2 profond et large séparé par une barrière de potentiel BP, mais cette structure étant encadrée par deux couches de confinement 10' et 18' à composition graduelle telle que la bande de conduction présente deux flancs en forme de vallée. Ce type de confinement, connu en soi, est désigné parfois par le terme GRINSCH signifiant "Graded Index Separate Confinement Heterostructure". Ce type de confinement améliore à la fois la qualité du mode optique et la qualité de la collection des électrons et des trous dans le puits quantique, donc la rapidité du dispositif.

Enfin, la figure 5 (a, b) montre la structure générale de l'amplificateur selon l'invention. Telle que représentée, la structure comprend une électrode inférieure 6 déposée sous un substrat 8, lequel substrat porte, sur sa face supérieure, une hétérostructure en forme de mésa M, avec, successivement, et comme illustré sur la partie b, des couches déjà rencontrées à savoir une couche inférieure de confinement 10, un premier puits étroit 12, une barrière 14, un second puits large 16, et enfin une couche supérieure de confinement 18. L'ensemble est recouvert d'une couche de contact 20 fortement dopée et d'une électrode supérieure 22.

Par ailleurs, sur chacune des faces latérales de l'ensemble, on trouve une couche semiréfléchissante, à savoir 30 sur la face avant (visible sur la figure 5) (partie a) et 32 sur la face arrière (cachée sur la figure). Comme expliqué plus haut, ces couches remplissent simultanément une double fonction : un antireflet pour la longueur d'onde d'amplification et une semiréflexion pour la longueur d'onde de l'effet laser chargé de vider le puits poubelle.

A titre d'exemple non limitatif, le substrat 8 peut être en InP dopé n+, l'hétérostructure M en InGaAsP avec les compositions données plus haut. L'électrode inférieure 6 peut être en or-germanium et le contact ohmique 22 en or-zinc. La structure mésa M peut être recouverte d'une couche d'InP.

## Revendications

1. Amplificateur optique à faible temps de commutation, comprenant, sur un substrat (8), un empilement de couches comprenant :
- une couche de confinement optique (10),
- une première couche (12), en un premier semiconducteur (SC₁) ayant une première bande interdite (Eg₁) et ayant une première épaisseur (e₁),
- une deuxième couche (14) en un deuxième semiconducteur (SC₂) ayant une deuxième bande interdite (Eg₂) plus large que la première bande interdite (Eg₁) du premier semiconducteur, cette deuxième couche ayant une deuxième épaisseur (e₂),
- une troisième couche (16), en un troisième semiconducteur (SC₃) ayant une troisième bande interdite (Eg₃) inférieure à la première bande interdite (Eg₁) du premier semiconducteur (SC₁), cette troisième couche (16) ayant une troisième épaisseur (e₃) plus grande que la première épaisseur (e₁) de la première couche (12),
- une autre couche de confinement optique (18),
- une couche de contact (20),
- une électrode inférieure (6) déposée sous le substrat (8) et une électrode supérieure (22) déposée sur la couche de contact (20),
cet empilement comprenant ainsi un puits quantique peu profond (P1) dans la première couche (12) couplé à un puits quantique profond (P2) dans la troisième couche (16) à travers une barrière de potentiel (BP) dans la deuxième couche (14), cet empilement ayant deux faces latérales,
cet amplificateur étant caractérisé par le fait que les deux faces latérales de l'empilement sont recouvertes de deux couches transparentes (30, 32) qui sont choisies dans leur nature et leur épaisseur pour constituer des couches antireflet pour une longueur d'onde (λ₁) correspondant à l'énergie de la première bande interdite (Eg₁) du premier semiconducteur (SC₁) constituant le puits quantique peu profond (P1) et pour constituer des couches semiréfléchissantes pour une longueur d'onde (λ₂) correspondant à l'énergie de la troisième bande interdite (Eg₃) du troisième semiconducteur (SC₃) constituant le puits quantique profond (P2), l'amplification optique s'effectuant à la longueur d'onde (λ₁) correspondant au puits peu profond (P1), un effet laser chargé de dépeupler le puits se produisant à la longueur d'onde (λ₂) correspondant au puits profond (P2).

2. Amplificateur selon la revendication 1, caractérisé par le fait que l'empilement comprend en outre une quatrième couche identique à la deuxième et une cinquième couche identique à la première, cet empilement comprenant ainsi un puits quantique profond et large (P2) encadré par deux puits quantiques peu profonds et étroits (P1, P'1).

3. Amplificateur selon la revendication 1 ou 2, caractérisé par le fait que l'épaisseur (e₁) de la première (et cinquième) couche et l'épaisseur (e₃) de la troisième couche sont telles que le premier niveau d'énergie (E₁) du (des) puits peu profond(s) et étroit(s) (P1) est à la même hauteur que l'un des niveaux supérieurs d'énergie (E'₂) du puits profond et large (P2).

4. Amplificateur selon la revendication 1, caractérisé par le fait que les deux couches de confinement (10, 18) ont des compositions graduelles.

5. Amplificateur selon l'une quelconque des revendications 1 à 5, caractérisé par le fait que l'énergie de la première bande interdite (Eg₁) correspondant au puits peu profond et étroit (P1) correspond à une longueur d'onde (λ₁) de 1,5 µm.

6. Amplificateur selon la revendication 5, caractérisé par le fait que le premier semiconducteur (SC₁) est en InGaAs avec une proportion de In de 52%.

7. Amplificateur selon la revendication 5, caractérisé par le fait que l'énergie de la troisième bande interdite (Eg₂) correspondant au puits profond et large (P2) correspond à une longueur d'onde (λ₂) de 1,9 µm.

8. Amplificateur selon la revendication 7, caractérisé par le fait que le troisième semiconducteur (SC₃) est en InGaAs avec une proportion de In de 65%.

## Patentansprüche

1. Optischer Verstärker mit kurzer Schaltzeit, der auf einem Substrat (8) einen Stapel aus folgenden Schichten umfaßt:
- eine optische Einschließungsschicht (10),
- eine erste Schicht (12) aus einem ersten Halbleiter (SC₁) mit einem ersten verbotenen Band (Eg₁) und einer ersten Dicke (e₁),
- eine zweite Schicht (14) aus einem zweiten Halbleiter (SC₂) mit einem zweiten verbotenen Band (Eg₂), breiter als das erste verbotene Band (Eg₁) des ersten Halbleiters, wobei diese zweite Schicht eine zweite Dicke (e₂) hat,
- eine dritte Schicht (16) aus einem dritten Halbleiter (SC₃) mit einem dritten verbotenen Band (Eg₃), niedriger als das erste verbotene Band (Eg₁) des ersten Halbleiters (SC₁), wobei diese dritte Schicht (16) eine dritte Dicke (e₃) hat, größer als die erste Dicke (e₁) der ersten Schicht (12),
- eine weitere optische Einschließungsschicht (18),
- eine Kontaktschicht (20),
- eine untere Elektrode (6), abgeschieden unter dem Substrat (8), und eine obere Elektrode (22), abgeschieden auf der Kontaktschicht (20),
wobei dieser Stapel somit einen wenig tiefen Potential- bzw. Quantentopf (P1) in der ersten Schicht (12) umfaßt, gekoppelt, durch eine Potentialbarriere (BP) in der zweiten Schicht (14), mit einem tiefen Quantentopf (P2) in der dritten Schicht (16), dieser Stapel zwei Seitenflächen hat und dieser Verstärker **dadurch gekennzeichnet** ist, daß die beiden Seitenflächen des Stapels bedeckt sind von zwei transparenten Schichten (30, 32), die in ihrer Art und ihrer Dicke so gewählt sind, daß sie Antireflex-Schichten bilden für eine Wellenlänge (λ₁), die der Energie des ersten verbotenen Bandes (Eg₁) des ersten, den wenig tiefen Quantentopf (P1) bildenden Halbleiters (SC₁) entspricht, und um halbreflektierende Schichten zu bilden für eine Wellenlänge (λ₂), die der Energie des dritten verbotenen Bandes (Eg₃) des dritten, den tiefen Quantentopf (P2) bildenden Halbleiters (SC₃) entspricht, wobei die optische Verstärkung bei der dem wenig tiefen Topf (P1) entsprechenden Wellenlänge (λ₁) erfolgt und ein Lasereffekt mit der dem tiefen Topf entsprechenden Wellenlänge (λ₂) erzeugt wird, um den Topf zu entvölkern bzw. zu leeren.

2. Verstärker nach Anspruch 1, dadurch gekennzeichnet, daß der Stapel außerdem eine vierte, mit der zweiten Schicht identische Schicht umfaßt und eine fünfte Schicht, identisch mit der ersten, wobei dieser Stapel somit einen tiefen und breiten Quantentopf (P2) umfaßt, umgeben von zwei wenig tiefen, schmalen Quantentöpfen (P1, P'1).

3. Verstärker nach Anspruch 1 oder 2, dadurch gekennzeichnet, daß die Dicke (e₁) der ersten und fünften Schicht und die Dicke (e₃) der dritten Schicht so sind, daß das erste Energieniveau (E₁) des (der) wenig tiefen, schmalen Quantentopfs (Quantentöpfe) (P1) sich auf gleicher Höhe befindet wie eines der oberen Energieniveaus (E'₂) des tiefen und breiten Topfs (P2).

4. Verstärker nach Anspruch 1, dadurch gekennzeichnet, daß die beiden Einschließungsschichten (10, 18) graduelle Zusammensetzungen haben.

5. Verstärker nach einem der Ansprüche 1 bis 5, dadurch gekennzeichnet, daß die Energie des dem wenig tiefen, schmalen Topf (P1) entsprechenden ersten verbotenen Bandes (Eg₁) einer Wellenlänge (λ₁) von 1,5µm entspricht.

6. Verstärker nach Anspruch 5, dadurch gekennzeichnet, daß der erste Halbleiter (SC₁) aus InGaAs mit einem In-Anteil von 52% ist.

7. Verstärker nach Anspruch 5, dadurch gekennzeichnet, daß die dem tiefen und breiten Topf (P2) entsprechende Energie des dritten verbotenen Bands (Eg₂) einer Wellenlänge (λ₂) von 1,9µm entspricht.

8. Verstärker nach Anspruch 7, dadurch gekennzeichnet, daß der dritte Halbleiter (SC₃) aus InGaAs mit einem In-Anteil von 65% ist.

## Claims

1. Optical amplifier with a short switching time comprising, on a substrate (8), a stack of layers incorporating:
- an optical confinement layer (10),
- a first layer (12) of a first semiconductor (SC₁) having a first forbidden band (Eg₁) and having a first thickness (e₁),
- a second layer (14) of a second semiconductor (SC₂) having a second forbidden band (Eg₂) wider than the first forbidden band (Eg₁) of the first semiconductor, said second layer having a second thickness (e₂),
- a third layer (16) of a third semiconductor (SC₃) having a third forbidden band (Eg₃) lower than the first forbidden (Eg₁) of the first semiconductor (SC₁), said third layer (16) having a third thickness (e₃) greater than the first thickness (e₁) of the first layer (12),
- another optical confinement layer (18),
- a contact layer (20),
- a lower electrode (6) deposited beneath the substrate (8) and an upper electrode (22) deposited on the contact layer (20),
said stack thus having a relatively shallow quantum well (P1) in the first layer (12) coupled to a deep quantum well (P2) in the third layer (16) across a potential barrier (BP) in the second layer (14), said stack having two lateral faces,
said amplifier being characterized in that the two lateral faces of the stack are covered by two transparent layers (30, 32), whose nature and thickness are chosen for constituting antireflection layers for a wavelength (λ₁) corresponding to the energy of the first forbidden band (Eg₁) of the first semiconductor (SC₁) constituting the relatively shallow quantum well (P1) and for constituting semireflecting layers for a wavelength (λ₂) corresponding to the energy of the third forbidden band (Eg₃) of the third semiconductor (SC₃) constituting the deep quantum well (P2), optical amplification taking place at the wavelength (λ₁) corresponding to the relatively shallow well (P1), a laser effect for depopulating the well occurring at the wavelength (λ₂) corresponding to the deep well (P2).

2. Amplifier according to claim 1, characterized in that the stack also comprises a fourth layer identical to the second layer and a fifth layer identical to the first layer, said stack thus having a deep, wide quantum well (P2) surrounded by two relatively shallow and narrow quantum wells (P1, P'1).

3. Amplifier according to claim 1 or 2, characterized in that the thickness (e₁) of the first and fifth layers and the thickness (e₃) of the third layer are such that the first energy level (E₁) of the relatively shallow and narrow wells (P1) is at the same height as one of the upper energy levels (E'₂) of the deep and wide well (P2).

4. Amplifier according to claim 1, characterized in that the two confinement layers (10, 18) have gradual compositions.

5. Amplifier according to one of the claims 1 to 5, characterized in that the energy of the first forbidden band (Eg₁) corresponding to the relatively shallow and narrow well (P1) corresponds to a wavelength (λ₁) of 1.5 µm.

6. Amplifier according to claim 5, characterized in that the first semiconductor (SC₁) is of InGaAs with an In proportion of 52%.

7. Amplifier according to claim 5, characterized in that the energy of the third forbidden band (Eg₂) corresponding to the deep and wide well (P2) corresponds to a wavelength (λ₂) of 1.9 µm.

8. Amplifier according to claim 7, characterized in that the third semiconductor (SC₃) is of InGaAs with an In proportion of 65%.
